(19) Europäisches Patentamt / European Patent Office / Office européen des brevets

(11) **EP 3 139 498 A1**

(12) **EUROPEAN PATENT APPLICATION**

(43) Date of publication:
08.03.2017  Bulletin 2017/10

(51) Int Cl.:
*H03F 1/22* (2006.01)        *H03F 1/34* (2006.01)
*H03F 3/193* (2006.01)      *H03F 3/195* (2006.01)
*H03F 3/21* (2006.01)

(21) Application number: 15183224.3

(22) Date of filing: 01.09.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(71) Applicant: **Nokia Technologies Oy**
**02610 Espoo (FI)**

(72) Inventor: **ÖSTMAN, Kim**
**00530 Helsinki (FI)**

(74) Representative: **Nokia Corporation**
**Intellectual Property Department**
**Karakaari 7**
**02610 Espoo (FI)**

(54)   **METHOD AND APPARATUS FOR AMPLIFYING SIGNALS**

(57)    There are disclosed various methods and apparatuses for amplifying a signal. In some embodiments the method a signal is provided to an input of a first transconducting element. An amplified signal is formed on the basis of the input signal by the first transconducting element and a second transconducting element. The amplified signal is used to form an inverted signal, wherein the inverted signal is provided to another input of the first transconducting element. In some embodiments the apparatus comprises means for implementing the method.

Fig. 2a

Printed by Jouve, 75001 PARIS (FR)

**Description**

## TECHNICAL FIELD

The present invention relates to a method for amplifying signals and an apparatus for amplifying signals.

## BACKGROUND

This section is intended to provide a background or context to the invention that is recited in the claims. The description herein may include concepts that could be pursued, but are not necessarily ones that have been previously conceived or pursued. Therefore, unless otherwise indicated herein, what is described in this section is not prior art to the description and claims in this application and is not admitted to be prior art by inclusion in this section.

In some apparatuses a low-noise amplifier (LNA) may be used to amplify signals so that noise possibly contributed by the amplifier is as weak as possible. These kinds of amplifiers may be used, for example, in radio receivers in a so called radio frequency (RF) front end. The low noise amplifier is intended to amplify possibly quite weak signals received by an antenna before the received signals are coupled to a mixer for converting the radio frequency signals to intermediate frequency (IF) signals or to baseband (BB) signals.

Receivers implemented on semiconductor circuits such as complementary metal oxide silicon circuits (CMOS) may operate with differential signaling. While differential signaling may consume more power and circuit area compared to single-ended solutions, the differential signaling may enable doubled signal swing and better noise immunity. However, differential low noise amplifiers may need two high-frequency input/output (I/O) pads on the integrated circuit instead of one. Especially multi-band/multi-mode receivers may use several parallel low noise amplifiers wherein at least some circuit area may be saved if a single-ended input could be utilized by the low noise amplifier. This may be achieved by performing single-ended to differential (i.e., unbalanced to balanced) conversion on-chip in the low noise amplifier structure.

## SUMMARY

Various embodiments provide a method and apparatus for amplifying signals and an apparatus for amplifying signals.

Various aspects of examples of the invention are provided in the detailed description.

According to a first aspect, there is provided a method comprising:

> providing a signal to an input of a first transconducting element;
> forming an amplified signal on the basis of the input signal by the first transconducting element and a second transconducting element;
> using the amplified signal to form an inverted signal; and
> providing the inverted signal to another input of the first transconducting element.

According to a second aspect, there is provided an apparatus comprising:

> a first transconducting element comprising an input for inputting a signal;
> a second transconducting element;
> wherein the first transconducting element and the second transconducting element are adapted for forming an amplified signal on the basis of the input signal;
> an element for forming an inverted signal from the amplified signal; and
> a feedback element for providing the inverted signal to another input of the first transconducting element.

According to a third aspect, there is provided an apparatus comprising:

> means for providing a signal to an input of a first transconducting element;
> means for forming an amplified signal on the basis of the input signal by the first transconducting element and a second transconducting element;
> means for using the amplified signal to form an inverted signal; and
> means for providing the inverted signal to another input of the first transconducting element.

## BRIEF DESCRIPTION OF THE DRAWINGS

For a more complete understanding of example embodiments of the present invention, reference is now made to the following descriptions taken in connection with the accompanying drawings in which:

Figure 1 shows a simplified block diagram of a device according to an example embodiment;
Figure 2a illustrates as a simplified circuit diagram the structure of an amplifier, in accordance with an embodiment;
Figure 2b illustrates as a simplified diagram an example of the structure of an amplifier utilizing cascode construction, in accordance with an embodiment;
Figure 2c illustrates as a simplified diagram an example of the structure of an amplifier using resistive impedances, in accordance with an embodiment;
Figure 2d illustrates as a simplified diagram an example of the structure of an amplifier using both capacitive and resistive impedances, in accordance with an embodiment;
Figure 2e illustrates as a simplified diagram an example of the structure of an amplifier using frequency tuned load impedances, in accordance with an embodiment;
Figure 2f illustrates as a simplified diagram an example of the structure of an amplifier using a capacitance at a feedback loop, in accordance with an embodiment;
Figure 2g illustrates as a simplified circuit diagram the structure of an amplifier of Figure 2a using p-type transistors, in accordance with an embodiment;
Figure 3a illustrates a headroom loss in volts as a function of a common-gate stage load resistance and a headroom loss in volts as a function of the common-gate stage load resistance $R_{CG}$ when no feedback has been used, in accordance with an embodiment;
Figures 3b and 3c illustrate some simulation results of a noise figure and gain of the amplifier for different values of load resistance and attenuation factor, in accordance with another embodiment;
Figure 4 shows a block diagram of an apparatus according to an example embodiment;
Figure 5 shows an apparatus according to an example embodiment;
Figure 6 shows an example of an arrangement for wireless communication comprising a plurality of apparatuses, networks and network elements.

## DETAILED DESCRIPTON OF SOME EXAMPLE EMBODIMENTS

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

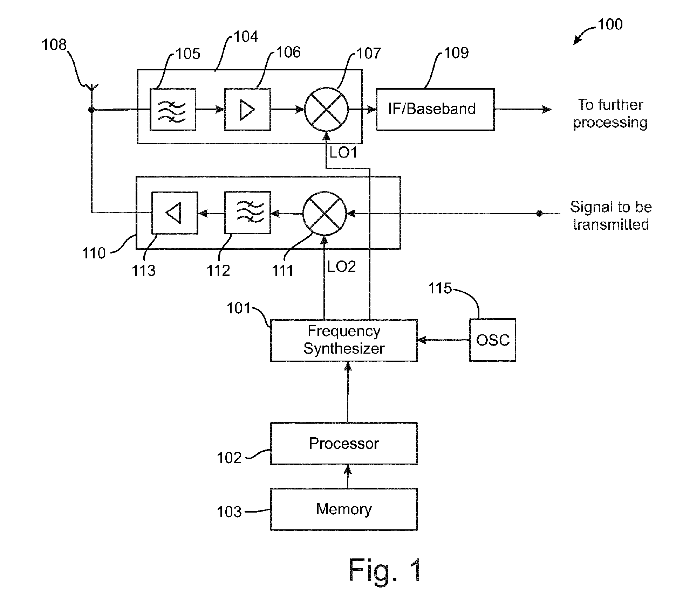

Figure 1 depicts an example of a part of a device 100, which may be, for example, a mobile device such as a mobile phone, but may also be another device comprising an amplifier 106. The device 100 may be constructed to include the frequency synthesizer 101 for generating one or more oscillator signals. The device may comprise one or more data processors 102 for controlling the operations of the device, in accordance with an embodiment. The data processor 102 operates in accordance with program instructions stored in at least one storage medium, such as at least one memory 103. The data processor 102 may control the frequency synthesizer 101 for setting the output frequency/frequencies of the frequency synthesizer 101. These output frequencies form one or more local oscillator signals that may be applied simultaneously to an RF receiver circuitry 104. The RF receiver circuitry 104 may include one or multiple instances of filters 105, amplifiers 106 and mixers 107. The RF receiver circuitry 104 may be configured to be connected with at least one, and possibly several antennas 108, and may operate to simultaneously receive and down-convert multiple reception channels in multiple frequency bands. The RF receiver circuitry 104 may be implemented e.g. as a single direct conversion receiver, as a plurality of direct conversion receivers, as a single superheterodyne-type receiver or as a plurality of superheterodyne-type receivers. In either case the down-converted signals from multiple reception channels are provided to at least one baseband circuitry block 109 to demodulate and decode received signaling and other data.

The device of Figure 1 also comprises an RF transmitter 110 for transmitting radio frequency signals. The transmitter 110 may comprise one or more mixers 111 adapted to receive signals to be transmitted and a local oscillator signal LO2. The mixing result may be provided to a band pass filter 112 to filter out mixing results which are out of the transmission band, and a power amplifier 113 to amplify the RF signals before passing them to one or more antennas 108. The one or more antennas 108 may be the same one or more antennas than the RF receiver circuitry 104 uses or different antenna(s).

The RF receiver circuitry 104, the RF transmitter 110 and/or the baseband circuitry 109 may be embodied as an integrated circuit. In some embodiments the RF receiver circuitry 104, the RF transmitter 110 and the baseband circuitry 109 or parts of them may be embodied in the same integrated circuit, and in some other embodiments they may be embodied in different integrated circuits. In some embodiments all of the circuitry shown in Figure 1, including the data processor 102 and possibly also the memory 103, may be embodied in one integrated circuit module or package.

In some embodiments all or some of the functionality of the frequency synthesizer 101 may be embodied by the data processor 102 or by another data processor, such as a high speed digital signal processor operating under control of a stored program.

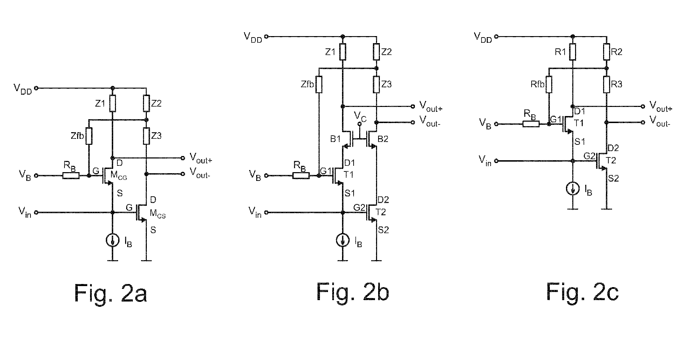

Figure 2a depicts as a simplified circuit diagram a principle of the amplifier 106, in accordance with an embodiment. The amplifier 106 may be, for example, a low noise amplifier with balun functionality. The amplifier 106 of Figure 2a may be based on one common-gate stage ($M_{CG}$) and one common-source stage ($M_{CS}$) which are connected in parallel. Both the common-gate stage $M_{CG}$ and the common-source stage $M_{CS}$ may operate on the single-ended input signal $V_{in}$. The common-source stage $M_{CS}$ inverts the input signal $V_{in}$ and by designing substantially equal gains for both the common-gate stage $M_{CG}$ and common-source stage $M_{CS}$ an amplified differential version of the input signal may be obtained at a differential output $V_{out+}$, $V_{out-}$.

The common-gate stage $M_{CG}$ may comprise a first transconductance element such as a transistor, and the common-source stage $M_{CS}$ may comprise a second transconductance element such as a transistor. This will be illustrated later in this specification in connection with description of Figures 2c-2f.

The first transconductance element and the second transconductance element may be, for example, field effect transistors (FET), such as metal-oxide silicon FETs (MOSFET) or junction gate field effect transistors (JFET), or other appropriate kinds of transistors, such as bipolar transistors.

If bipolar transistors are uses as the transconductance elements, the common-gate configuration may also be called as common-base configuration and the common-source configuration may also be called as common-emitter configuration. In the circuitries, a base of a bipolar transistor may be regarded as the gate of the field effect transistor, an emitter of a bipolar transistor may be regarded as the source of the field effect transistor, and a collector of a bipolar transistor may be regarded as the drain of the field effect transistor.

A transconductance of the common-gate stage $M_{CG}$ may be raised by creating and feeding the inverted version of the single-ended input signal to the common-gate stage $M_{CG}$. This may modify the matching condition of the common-gate stage $M_{CG}$ compared to solutions without the feedback. The inverted version of the input signal may not be directly available in the single-ended construction. A replica of the inverted input signal may then be obtained by using the inverted output voltage $V_{out-}$ and feeding it via a voltage divider to the gate of the common-gate stage $M_{CG}$ attenuated by an attenuation factor, which is the inverse of the stage voltage gain. In effect, the circuitry thus mimics the operation of cross-coupling on common-gate stages without requiring a differential input.

The voltage division may be obtained, for example, by using in-series connected impedances Z2, Z3 and coupling a mutual connection of the impedances Z2, Z3 to the gate of the common-gate stage $M_{CG}$ via a feedback impedance Zfb. The division ratio (attenuation factor) may be determined by the following equation:

$$r = Z2/(Z2+Z3) \tag{1}$$

Feeding the inverted version of the single-ended input signal to the common-gate stage $M_{CG}$ may provide a higher maximum gain of the amplifier, lower noise figure (NF) and/or greater output headroom for improved linearity and design freedom.

In accordance with an embodiment, the feedback may affect the input matching condition of the common-gate stage $M_{CG}$ such that it becomes $g_{m,CG} = 10$ mS for a 50-$\Omega$ system instead of $g_{m,CG} = 20$ mS for a 50-$\Omega$ system.

Figure 2b shows a modified structure of the amplifier of Figure 2a. In this structure cascode stages are used for both the common-gate stage $M_{CG}$ and the common-source stage $M_{CS}$. In other words, the output of the common-gate stage $M_{CG}$ is coupled to a first buffer element B1, and the output of the common-source stage $M_{CG}$ is coupled to a second buffer element B2. The output of the first buffer element B1 may then be used as the positive voltage output $V_{out+}$, and the output of the second buffer element B2 may then be used as the inverted voltage output $V_{out-}$. The cascode stages may improve the isolation between the amplifier input and the amplifier output, and they may also extend the operating frequency range of the input by reducing the Miller effect on the common-source stage $M_{CS}$.

Figures 2c-2f illustrate some example implementations of the amplifier 106, based on the structure of Figure 2a.

In Figure 2c a simplified diagram of the amplifier structure of Figure 2a using resistive impedances is illustrated, in accordance with an embodiment. The common-gate stage $M_{CG}$ is formed by a first transistor T1 and the common-source $M_{CS}$ stage is formed by a second transistor T2. The first transistor T1 is provided with a bias voltage $V_B$ via a bias resistor $R_B$ to set a correct operation point for the first transistor. A source S1 of the first transistor T1 is coupled to a gate G2 of the second transistor T2. The gate G2 of the second transistor T2 is also used as a single-ended input for the signal to be amplified $V_{in}$. A constant current source $I_B$ is coupled between the source S1 of the first transistor T1 and ground for biasing the first transistor T 1. A drain D1 of the first transistor T1 forms a positive output $V_{out+}$ of the amplifier 106 and a drain D2 of the second transistor T2 forms a negative output $V_{out-}$ of the amplifier 106. An operating voltage $V_{DD}$ is supplied to the drain D1 of the first transistor T1 via a first resistance R1, and an operating voltage $V_{DD}$ is supplied to the drain D2 of the second transistor T2 via a second resistance R2 and a third resistance R3, which are connected in series. The second resistance R2 and the third resistance R3 form the voltage divider, wherein an attenuated, inverted output voltage $V_{out-}$ is provided via the feedback resistance Rfb to the gate of the first transistor T1.

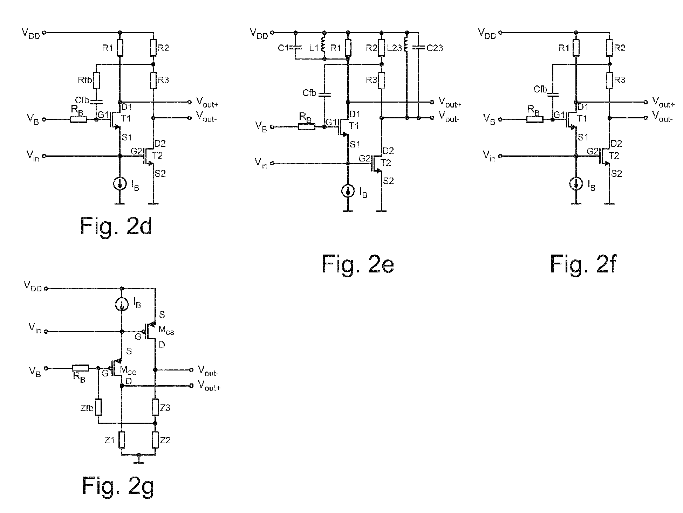

Figure 2d illustrates a simplified diagram of the amplifier structure of Figure 2a using resistive impedances and a capacitance Cfb at the feedback loop, in accordance with an embodiment. The capacitance Cfb may help to not complicate the bias conditions at the gate of the common-gate stage $M_{CG}$. The other elements of the amplifier of Figure 2d may be similar to the example of Figure 2c.

In Figure 2e a simplified diagram of the amplifier structure of Figure 2a using frequency tuned load impedances is illustrated, in accordance with an embodiment. The feedback loop only comprises a capacitance Cfb connected between the gate of the first transistor T1 and the mutual connection point of the second resistance R2 and the third resistance R3. The operating voltage $V_{DD}$ is supplied to the drain D1 of the first transistor T1 via a first resonance circuit formed of the first resistance R1, the first capacitance C1 and a first inductor L1, each connected in parallel. A second resonance circuit is formed between the inverted output $V_{out-}$ and the supply voltage $V_{DD}$ by using a second inductor L23 and a second capacitance C23.

Forming the feedback loop by the capacitance Cfb instead of the resistance Rfb may provide the benefit of separating the DC bias conditions of the common-gate stage $M_{CG}$ from those at the drain of the common-source stage $M_{CS}$, and of not adding substantially any noise.

In the construction of Figure 2e the differential outputs can be tuned to a given operating frequency by using the LC resonators $L_1/C_1$ and $L_{23}/C_{23}$. The first inductance $L_1$ and the second inductance $L_{23}$ may be realized together as one center-tapped inductor, where the center tap is connected to the voltage supply line $V_{DD}$. The first capacitance C1 and the second capacitance C23 can be implemented separately as in Figure 2e, or as one capacitor connected between the output nodes $V_{out+}$ and $V_{out}$. The use of these LC tuning circuits may make the amplifier 106 inherently narrowband in nature. Moreover, their placement in parallel with the resistances $R_1/R_2/R_3$ may be taken into account when selecting component values so that the loads seen by common-gate stage $M_{CG}$ and the common-source stage $M_{CS}$ are substantially equal.

In Figure 2f a simplified diagram of the amplifier structure of Figure 2a using both capacitive and resistive impedances is illustrated, in accordance with an embodiment. The feedback loop comprises the feedback capacitance Cfb without the feedback resistance Rfb of the embodiment of Figure 2c.

The lack of LC resonators may provide wideband operation and may avoid possible resonator-related difficulties for balancing the load impedances. Instead, this construction only uses resistances, where the common-source branch resistive-divider load R2/R3 may be sized such that its gain (attenuation) is substantially the inverse of the voltage gain of the branches, i.e., $\beta = 1/g_{m,CG}R_{CG}$. Using the markings of Figure 2f, in which the resistance R1 corresponds with the common-gate branch resistance $R_{CG}$, the gain may be expressed as $\beta = 1/g_{m,CG}R1$. $g_{m,CG}$ is the transconductance of the common-gate state, which corresponds to the transconductance of the first transistor T1. The feedback to the gate of the common-gate stage $M_{CG}$ is handled capacitively through the feedback capacitance $C_{fb}$, thus substantially avoiding any additional noise.

The transconductance of the common-source stage, in other words, the transconductance of the second transistor T2 in the embodiment of Figure 2f, may be selected so that it is twice a multiple of the scaling factor $m$ of the transconductance of the common-gate stage $M_{CG}$. Hence, the common-source stage $M_{CS}$ load resistor $R_{CS}$ (=R2+R3) may be designed as $R_{CG}/m$ and the transconductance of the common-source stage would be $g_{m,CS} = 2{*}m{*}g_{m,CG}$.

Figure 2g depicts as a simplified circuit diagram the principle of the amplifier 106 of Figure 2a, but using p-type transistors instead of n-type transistors, in accordance with an embodiment.

Transconductance-boosting the common-gate stage $M_{CG}$ may halve the required DC bias current of the stage and thus may halve the voltage headroom loss for the load resistance $R_{CG}$ of the common-gate stage. The increased available headroom may enable further versatility through a choice between two alternative design strategies. On the one hand, the halved headroom loss for a constant $R_{CG}$ can be used to provide improved linearity without affecting the noise figure or the voltage gain ($A_v$). Furthermore, the amplifier may allow to double $R_{CG}$ to obtain lower voltage swing headroom, but to simultaneously obtain much lower noise figure and doubled voltage gain. The doubled voltage gain may also substantially reduce the noise contribution of subsequent receiver stages, thus leading to further reduced noise figure of the receiver.

Using the above mentioned notations and equations, the load resistances R1, R2, R3 may be selected as follows, in accordance with an embodiment. R1 = $R_{CG}$, R2 = $\beta R_{CG}/m$, and R3 = $(1-\beta)R_{CG}/m$. Thus, the common-gate stage $M_{CG}$ and the common-source stage $M_{CS}$ may both retain substantially equal voltage gains through this scaling and thus may retain the balun property of the amplifier 106, but the noise of the dominating the common-source stage $M_{CS}$ may be reduced.

Specifically, the potentially doubled value of the common-gate stage $M_{CG}$ load resistance $R_{CG}$ in the amplifier may allow to use up to a doubled scaling factor $m$ before making the common-source stage $M_{CS}$ load resistor ($R_{CS} = R_{CG}/m$) unreasonably small. A very small size may be a problem in terms of fabrication process variations. This might lead to degraded common-gate stage $M_{CG}$/common-source stage $M_{CS}$ gain balancing and thus degraded balun operation. The potentially doubled scaling factor $m$ may further reduce the noise figure of the amplifier 106.

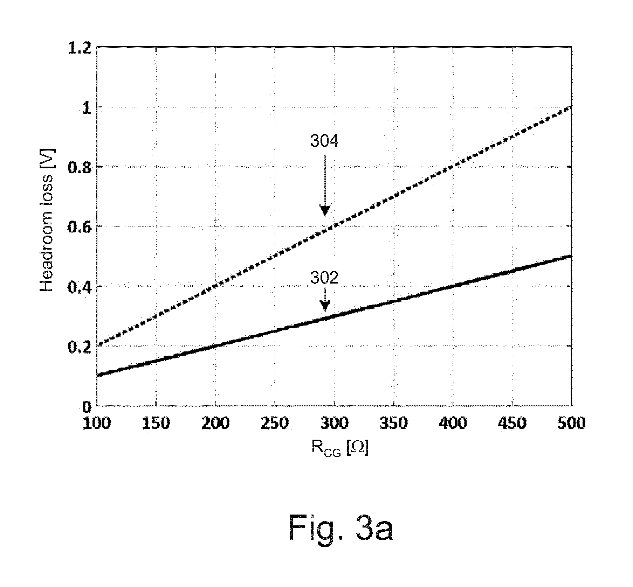

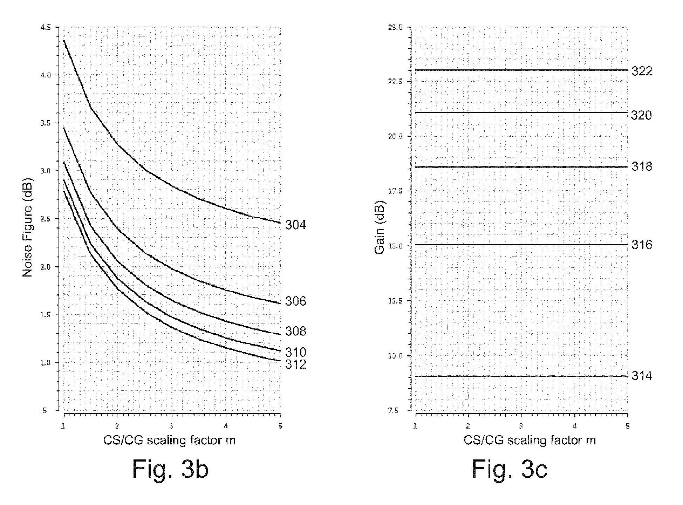

Figure 3a illustrates the headroom loss in volts as a function of the common-gate stage load resistance $R_{CG}$ (line 302) and the headroom loss in volts as a function of the common-gate stage load resistance $R_{CG}$ (line 304) when no feedback has been used, in accordance with an embodiment. Figures 3b and 3c illustrate some simulation results of the noise figure and gain of the amplifier 106 for different values of $R_{CG}$ and $m$, in accordance with an embodiment. In the simulations it was assumed that the transistor noise constant is $\gamma = 2/3$. For example, if $R_{CG} = 200$ and $m = 2$, the noise figure NF is about 2.4 dB (curve 306) and the gain is about 15 dB (curve 316). The other simulated results were as follows: the curve 304 illustrates the noise figure and the curve 314 illustrates the gain, when $R_{CG} = 100$; the curve 308 illustrates the noise figure and the curve 318 illustrates the gain, when $R_{CG} = 300$; the curve 310 illustrates the noise figure and the curve 320 illustrates the gain, when $R_{CG} = 400$; and the curve 312 illustrates the noise figure and the curve 322 illustrates the gain, when $R_{CG} = 500$.

In accordance with an embodiment, the amplifier may be designed so that $R_{CG} = 400$ and $m = 2$, which leads to the noise figure of 1.9 dB and gain = 21 dB. In accordance with another embodiment, the amplifier may be designed so that $R_{CG} = 400$ and $m = 3$, wherein this may lead to a further improved noise figure NF = 1.5 dB.

The amplifier structure presented above may provide greater design freedom and performance versatility than amplifier structures which do not utilize the feedback. The increased voltage headroom of the common-gate stage $M_{CG}$ may improve linearity, without a penalty on $A_v$/NF. Further, the common-gate stage $M_{CG}$ load resistor size may be doubled to obtain the same headroom as in amplifier structures which do not utilize the feedback, but with substantially reduced noise figure and increased voltage gain $A_v$ that in turn may decrease the noise contribution of subsequent receiver stages. The amplifier structure may also enable greater common-gate stage $M_{CG}$ / common-gate stage $M_{CS}$ scaling, thus decreasing the noise figure NF of the amplifier and further stages of the receiver.

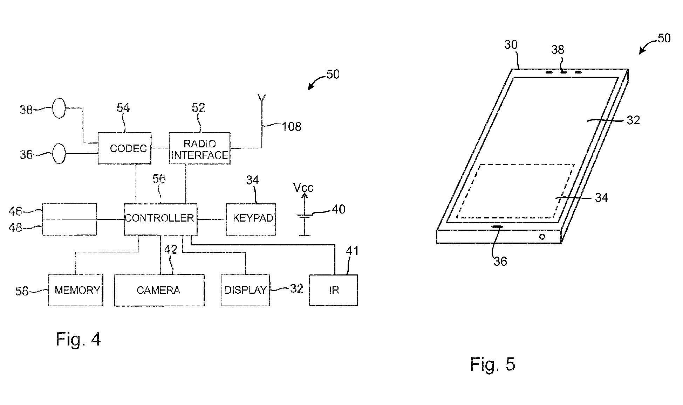

The following describes in further detail suitable apparatus and possible mechanisms for implementing the embodiments of the invention. In this regard reference is first made to Figure 4 which shows a schematic block diagram of an exemplary apparatus or electronic device 50 depicted in Figure 5, which may incorporate a transmitter according to an embodiment of the invention.

The electronic device 50 may for example be a mobile terminal or user equipment of a wireless communication system. However, it would be appreciated that embodiments of the invention may be implemented within any electronic device or apparatus which may require transmission of radio frequency signals.

The apparatus 50 may comprise a housing 30 for incorporating and protecting the device. The apparatus 50 further may comprise a display 32 in the form of a liquid crystal display. In other embodiments of the invention the display may be any suitable display technology suitable to display an image or video. The apparatus 50 may further comprise a keypad 34. In other embodiments of the invention any suitable data or user interface mechanism may be employed. For example the user interface may be implemented as a virtual keyboard or data entry system as part of a touch-sensitive display. The apparatus may comprise a microphone 36 or any suitable audio input which may be a digital or analogue signal input. The apparatus 50 may further comprise an audio output device which in embodiments of the invention may be any one of: an earpiece 38, speaker, or an analogue audio or digital audio output connection. The apparatus 50 may also comprise a battery 40 (or in other embodiments of the invention the device may be powered by any suitable mobile energy device such as solar cell, fuel cell or clockwork generator). The term battery discussed in connection with the embodiments may also be one of these mobile energy devices. Further, the apparatus 50 may comprise a combination of different kinds of energy devices, for example a rechargeable battery and a solar cell. The apparatus may further comprise an infrared port 41 for short range line of sight communication to other devices. In other embodiments the apparatus 50 may further comprise any suitable short range communication solution such as for example a Bluetooth wireless connection or a USB/firewire wired connection.

The apparatus 50 may comprise a controller 56 or processor for controlling the apparatus 50. The controller 56 may be connected to memory 58 which in embodiments of the invention may store both data and/or may also store instructions for implementation on the controller 56. The controller 56 may further be connected to codec circuitry 54 suitable for carrying out coding and decoding of audio and/or video data or assisting in coding and decoding carried out by the controller 56.

The apparatus 50 may further comprise a card reader 48 and a smart card 46, for example a universal integrated circuit card (UICC) reader and a universal integrated circuit card for providing user information and being suitable for providing authentication information for authentication and authorization of the user at a network.

The apparatus 50 may comprise radio interface circuitry 52 connected to the controller and suitable for generating wireless communication signals for example for communication with a cellular communications network, a wireless communications system or a wireless local area network. The apparatus 50 may further comprise an antenna 108 connected to the radio interface circuitry 52 for transmitting radio frequency signals generated at the radio interface circuitry 52 to other apparatus(es) and for receiving radio frequency signals from other apparatus(es).

In some embodiments of the invention, the apparatus 50 comprises a camera 42 capable of recording or detecting imaging.

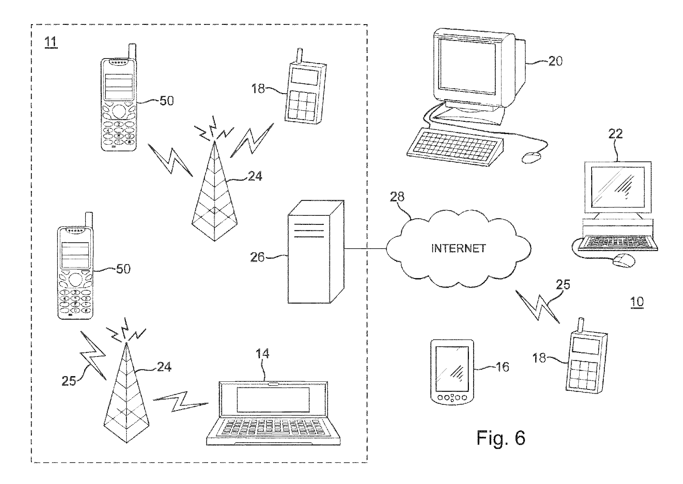

With respect to Figure 6, an example of a system within which embodiments of the present invention can be utilized is shown. The system 10 comprises multiple communication devices which can communicate through one or more networks. The system 10 may comprise any combination of wired and/or wireless networks including, but not limited to a wireless cellular telephone network (such as a global systems for mobile communications (GSM), universal mobile telecommunications system (UMTS), long term evolution (LTE) based network, code division multiple access (CDMA) network etc.), a wireless local area network (WLAN) such as defined by any of the IEEE 802.x standards, a Bluetooth personal area network, an Ethernet local area network, a token ring local area network, a wide area network, and the Internet.

For example, the system shown in Figure 6 shows a mobile telephone network 11 and a representation of the internet 28. Connectivity to the internet 28 may include, but is not limited to, long range wireless connections, short range wireless connections, and various wired connections including, but not limited to, telephone lines, cable lines, power lines, and similar communication pathways.

The example communication devices shown in the system 10 may include, but are not limited to, an electronic device or apparatus 50, a combination of a personal digital assistant (PDA) and a mobile telephone 14, a PDA 16, an integrated messaging device (IMD) 18, a desktop computer 20, a notebook computer 22, a tablet computer. The apparatus 50 may be stationary or mobile when carried by an individual who is moving. The apparatus 50 may also be located in a mode of transport including, but not limited to, a car, a truck, a taxi, a bus, a train, a boat, an airplane, a bicycle, a motorcycle or any similar suitable mode of transport.

Some or further apparatus may send and receive calls and messages and communicate with service providers through a wireless connection 25 to a base station 24. The base station 24 may be connected to a network server 26 that allows communication between the mobile telephone network 11 and the internet 28. The system may include additional communication devices and communication devices of various types.

The communication devices may communicate using various transmission technologies including, but not limited to, code division multiple access (CDMA), global systems for mobile communications (GSM), universal mobile telecommunications system (UMTS), time divisional multiple access (TDMA), frequency division multiple access (FDMA), transmission control protocol-internet protocol (TCP-IP), short messaging service (SMS), multimedia messaging service (MMS), email, instant messaging service (IMS), Bluetooth, IEEE 802.11, Long Term Evolution wireless communication technique (LTE) and any similar wireless communication technology. A communications device involved in implementing various embodiments of the present invention may communicate using various media including, but not limited to, radio, infrared, laser, cable connections, and any suitable connection. In the following some example implementations of apparatuses utilizing the present invention will be described in more detail.

Although the above examples describe embodiments of the invention operating within a wireless communication device, it would be appreciated that the invention as described above may be implemented as a part of any apparatus comprising a circuitry in which radio frequency signals are transmitted and received. Thus, for example, embodiments of the invention may be implemented in a mobile phone, in a base station, in a computer such as a desktop computer or a tablet computer comprising radio frequency communication means (e.g. wireless local area network, cellular radio, etc.).

In general, the various embodiments of the invention may be implemented in hardware or special purpose circuits or any combination thereof. While various aspects of the invention may be illustrated and described as block diagrams or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention.

In the following some examples will be provided.

According to a first example, there is provided a method comprising:

  providing a signal to an input of a first transconducting element;
  forming an amplified signal on the basis of the input signal by the first transconducting element and a second transconducting element;
  using the amplified signal to form an inverted signal; and
  providing the inverted signal to another input of the first transconducting element.

In some embodiments the method comprises:

  generating the amplified signal as a differential output signal comprising a positive output signal and a negative output signal.

In some embodiments the method comprises:

  using the negative output signal to form the inverted signal.

In some embodiments the method comprises:

  feeding a signal amplified by the first transconducting element to a first load impedance for forming the positive output signal; and
  feeding a signal amplified by the second transconducting element to a second load impedance for forming the negative output signal.

In some embodiments the method comprises:

  forming the inverted signal by the second load impedance.

In some embodiments the method comprises:

  attenuating the inverted signal by the second load impedance by an attenuation factor.

According to a second example, there is provided an apparatus comprising:

  a first transconducting element comprising an input for inputting a signal;
  a second transconducting element;
  wherein the first transconducting element and the second transconducting element are adapted for forming an amplified signal on the basis of the input signal;
  an element for forming an inverted signal from the amplified signal; and
  a feedback element for providing the inverted signal to another input of the first transconducting element.

In some embodiments the apparatus is adapted to:

  generate the amplified signal as a differential output signal comprising a positive output signal and a negative output signal.

In some embodiments of the apparatus:

  the first transconducting element is coupled to a first load impedance for forming the positive output signal; and
  the second transconducting element is coupled to a second load impedance for forming the negative output signal.

In some embodiments of the apparatus:

  the second load impedance is a voltage divider to form an attenuated output signal, wherein the feedback element is coupled to the voltage divider to feed the attenuated output signal to another input of the first transconducting element.

In some embodiments of the apparatus the voltage divider comprises:

two impedances coupled in parallel, wherein a mutual coupling of the two impedances is coupled to the feedback element.

In some embodiments of the apparatus:

the first transconducting element is a part of a common-gate configuration; and
the second transconducting element is a part of a common-source configuration.

In some embodiments of the apparatus the load impedances comprise one or more of the following:

resistances;
LC resonators.

In some embodiments of the apparatus the feedback element comprises one of the following:

one or more resistances;
one or more capacitances;
one or more resistances and one or more capacitances coupled in series.

In some embodiments of the apparatus the first transconducting element and the second transconducting element are field effect transistors.
In some embodiments the apparatus is a part of a receiver.
In some embodiments the apparatus is a part of a wireless communication device.
According to a third example, there is provided an apparatus comprising:

means for providing a signal to an input of a first transconducting element;
means for forming an amplified signal on the basis of the input signal by the first transconducting element and a second transconducting element;
means for using the amplified signal to form an inverted signal; and
means for providing the inverted signal to another input of the first transconducting element.

In some embodiments the apparatus comprises:

means for generating the amplified signal as a differential output signal comprising a positive output signal and a negative output signal.

In some embodiments the apparatus comprises:

means for using the negative output signal to form the inverted signal.

In some embodiments the apparatus comprises:

means for feeding a signal amplified by the first transconducting element to a first load impedance for forming the positive output signal; and
means for feeding a signal amplified by the second transconducting element to a second load impedance for forming the negative output signal.

In some embodiments the apparatus comprises:

means for forming the inverted signal by the second load impedance.

In some embodiments the apparatus comprises:

means for attenuating the inverted signal by the second load impedance by an attenuation factor.

**Claims**

1. A method comprising:

   providing a signal to an input of a first transconducting element;
   forming an amplified signal on the basis of the input signal by the first transconducting element and a second transconducting element;
   using the amplified signal to form an inverted signal; and
   providing the inverted signal to another input of the first transconducting element.

2. The method according to claim 1 comprising:

   generating the amplified signal as a differential output signal comprising a positive output signal and a negative output signal; and
   using the negative output signal to form the inverted signal.

3. The method according to claim 2 comprising:

   feeding a signal amplified by the first transconducting element to a first load impedance for forming the positive output signal; and
   feeding a signal amplified by the second transconducting element to a second load impedance for forming the negative output signal.

4. The method according to claim 3 comprising:

   forming the inverted signal by the second load impedance.

5. The method according to claims 1 to 4 comprising:

   attenuating the inverted signal by the second load impedance by an attenuation factor.

6. An apparatus comprising:

   a first transconducting element comprising an input for inputting a signal;
   a second transconducting element;
   wherein the first transconducting element and the second transconducting element are adapted for forming an amplified signal on the basis of the input signal;
   an element for forming an inverted signal from the amplified signal; and
   a feedback element for providing the inverted signal to another input of the first transconducting element.

7. The apparatus according to claim 6, wherein the apparatus is adapted to:

   generate the amplified signal as a differential output signal comprising a positive output signal and a negative output signal.

8. The apparatus according to claim 7, wherein:

   the first transconducting element is coupled to a first load impedance for forming the positive output signal; and
   the second transconducting element is coupled to a second load impedance for forming the negative output signal.

9. The apparatus according to claim 8, wherein:

   the second load impedance is a voltage divider to form an attenuated output signal, wherein the feedback element is coupled to the voltage divider to feed the attenuated output signal to another input of the first transconducting element.

**10.** The apparatus according to claim 9, wherein the voltage divider comprises:

two impedances coupled in parallel, wherein a mutual coupling of the two impedances is coupled to the feedback element.

**11.** The apparatus according to claim 10, wherein the load impedances comprise one or more of the following:

resistances;
LC resonators.

**12.** The apparatus according to any of the claims 6 to 11, wherein:

the first transconducting element is a part of a common-gate or a common-base configuration; and
the second transconducting element is a part of a common-source or a common-emitter configuration.

**13.** The apparatus according to any of the claims 6 to 12, wherein the feedback element comprises one of the following:

one or more resistances;
one or more capacitances;
one or more resistances and one or more capacitances coupled in series.

**14.** The apparatus according to any of the claims 6 to 13, wherein the first transconducting element and the second transconducting element are field effect transistors.

**15.** The apparatus according to any of the claims 6 to 14, wherein the apparatus is a part of a receiver of a wireless communication device.

Fig. 1

Fig. 2a

Fig. 2b

Fig. 2c

Fig. 2d

Fig. 2e

Fig. 2f

Fig. 2g

Fig. 3a

Fig. 3b

Fig. 3c

Fig. 4

Fig. 5

Fig. 6

Europäisches
Patentamt

European
Patent Office

Office européen
des brevets

# EUROPEAN SEARCH REPORT

Application Number

EP 15 18 3224

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 264 281 B1 (RAJENDRAN GIREESH [IN] ET AL) 11 September 2012 (2012-09-11) * figures 3,4 * | 1-4,6-8, 12-15 | INV. H03F1/22 H03F1/34 H03F3/193 |
| X | US 2010/013562 A1 (STOCKINGER HERBERT [DE] ET AL) 21 January 2010 (2010-01-21) | 1-4,6-8, 12-15 | H03F3/195 H03F3/21 |
| A | * figure 3 * * figures 4,6 * | 9 | |
| A | US 2012/154056 A1 (GUO M; KUO M; KUO M C; SHI Y; SHIH Y; SHIH Y S; TANG S; TARNG S; TARNG) 21 June 2012 (2012-06-21) * figures 1,2 * | 1-15 | |
| A | US 2003/042983 A1 (HOLLENBECK NEAL W [US] ET AL) 6 March 2003 (2003-03-06) * figure 2 * | 1-15 | |
| A | US 2004/056722 A1 (SUTARDJA SEHAT [US]) 25 March 2004 (2004-03-25) * figures 4,5A,5B * | 1-15 | |

TECHNICAL FIELDS
SEARCHED      (IPC)

H03F

The present search report has been drawn up for all claims

| Place of search | Date of completion of the search | Examiner |
|---|---|---|
| Munich | 3 March 2016 | Kurzbauer, Werner |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 18 3224

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2016

| Patent document cited in search report | | | Publication date | Patent family member(s) | | | Publication date |
|---|---|---|---|---|---|---|---|
| US 8264281 | B1 | | 11-09-2012 | NONE | | | |
| US 2010013562 | A1 | | 21-01-2010 | DE<br>US | 102009033414<br>2010013562 | A1<br>A1 | 21-01-2010<br>21-01-2010 |
| US 2012154056 | A1 | | 21-06-2012 | CN<br>TW<br>US | 102545790<br>201228217<br>2012154056 | A<br>A<br>A1 | 04-07-2012<br>01-07-2012<br>21-06-2012 |
| US 2003042983 | A1 | | 06-03-2003 | US<br>WO | 2003042983<br>03021768 | A1<br>A1 | 06-03-2003<br>13-03-2003 |
| US 2004056722 | A1 | | 25-03-2004 | NONE | | | |

EPO FORM P0459

For more details about this annex : see Official Journal of the European Patent Office, No. 12/82